**Europäisches Patentamt**

**European Patent Office**

**Office européen des brevets**

(11) Veröffentlichungsnummer: **0 019 186**
**A1**

# EUROPÄISCHE PATENTANMELDUNG

(21) Anmeldenummer: 80102439.9

(22) Anmeldetag: 05.05.80

(51) Int. Cl.³: **H 01 L 21/48**
H 01 L 21/603, H 01 L 21/60

(30) Priorität: 17.05.79 DE 2919998

(43) Veröffentlichungstag der Anmeldung:
26.11.80 Patentblatt 80/24

(84) Benannte Vertragsstaaten:
AT BE FR GB IT NL

(71) Anmelder: SIEMENS AKTIENGESELLSCHAFT Berlin
und München
Postfach 22 02 61
D-8000 München 22(DE)

(72) Erfinder: Hacke, Hans-Jürgen, Dipl.-Ing.
Malojaweg 7
D-8000 München 71(DE)

(72) Erfinder: Penzl, Reinhold, Dipl.-Phys.
Alpspitzstrasse 15
D-8031 Eichenau(DE)

(72) Erfinder: Rauscher, Gerhard, Dipl.-Phys.
Kiem-Pauli-Weg 81
D-8014 Neubiberg(DE)

(72) Erfinder: Schuller, Lothar
Am Lindenberg 177
D-8134 Pöcking(DE)

(72) Erfinder: Wirbser, Oscar
Kreuzlingerstrasse 73
D-8034 Germering(DE)

(54) Befestigen der Anschlussdrähte von Halbleitersystemen auf den Trägerelementen.

(57) Mit Hilfe von Laserlicht wird eine Thermokompressionsverbindung der Anschlußdrähte von Halbleiterbauelementen auf unedlen Oberflächen der Trägermaterialien bei relativ niedriger Temperatur am Chip durchgeführt. Dafür kommen vorwiegend drei Methoden in Frage: Erwärmen der Verbindungsstelle mit fokussierter Laserstrahlung neben der Verbindungsstelle, Erwärmen der Verbindungsstelle bis eine flache Schmelzzone entsteht oder Verdampfen der Oberfläche an der Verbindungsstelle des Trägermaterials kurz vor dem Bondvorgang.

EP 0 019 186 A1

Croydon Printing Company Ltd.

SIEMENS AKTIENGESELLSCHAFT     Unser Zeichen
Berlin und München             VPA **79 P 7067**

Befestigen der Anschlußdrähte von Halbleitersystemen
auf den Trägerelementen.

Die Erfindung betrifft ein Verfahren zum Befestigen
der Anschlußdrähte von Halbleiterbauelementen (z.B.
Transistoren oder IC's) auf Anschlußelementen
(z.B. Systemträgern oder Einbaugehäusen) durch Thermokompression.

Das bisher bevorzugte Kontaktierverfahren für die Verbindung der Anschlußdrähte mit den Trägermaterialien
ist die Thermokompression. Die Thermokompression macht
sich die Erfahrung zunutze, daß gewisse Metalle beim Zusammenpressen unter Temperaturen, die weit unter dem
Schmelzpunkt liegen, an ihrer Grenzschicht eine Verbindung hoher mechanischer Festigkeit und guter
elektrischer Leitfähigkeit bilden. Eine sinnreiche
Version der Thermokompression ist die "Nagelkopf-
Kontaktierung". Hier wird z.B. ein Golddraht von

Wed 1 Kel /25.4.1979                              - 2 -

z.B. 20 µm ⌀ durch eine senkrecht angeordnete, meist heizbare Wolframkarbiddüse geführt, deren unterer lichter Durchmesser wenig größer ist als der des Golddrahtes. Nach Anschmelzen des Drahtes zu einer Kugel wird dieses Ende nagelkopfartig auf den Halbleiter kontaktiert. Das andere Ende wird auf dem mit Edelmetall (vorwiegend Gold) beschichteten Trägermaterial befestigt.

Um die relativ teuere Edelmetallschicht zu vermeiden, kann Thermokompression auf unedlen Oberflächen wie MS 90, CuFe, CuNi o. a. zwar bei Temperaturen über 400°C durchgeführt werden. Da eine kurzzeitige lokale Erwärmung bisher nicht möglich war, werden bei diesen hohen Temperaturen jedoch die Verbindungsstellen der durch Legieren, Löten oder Kleben auf dem Systemträger befestigten Chips geschädigt.

Der Erfindung liegt die Aufgabe zugrunde, mit möglichst einfachen Mitteln das eingangs genannte Verfahren ohne Edelmetallschicht auf dem Träger zu realisieren. Dieses Verfahren soll darüber hinaus für große Produktionsstückzahlen geeignet sein und die Automatisierbarkeit einschließen. Diese Aufgabe wird dadurch gelöst, daß durch ein berührungsloses Zuführen von Wärme in einem partiellen Bereich mittels Laserstrahlung fokussierter IR-Strahlung, UV-Strahlung oder fokussiertem Licht die Thermokompression auf unedlen Oberflächen der Verbindungsstellen bei relativ niedrigerer Temperatur durchgeführt und dabei in bekannter Weise zur Vermeidung von Oxidation des Trägermaterials Schutzgas verwendet wird. Auf diese Weise erreicht man, daß der

0019186

Aufwand für das Aufbringen von Edelmetallen vollkommen entfällt. Außerdem kann das Verfahren nach der Erfindung auf den vorhandenen Fertigungseinrichtungen mit gewissen Ergänzungen durchgeführt werden.

Nach einer Weiterbildung der Erfindung wird die Verbindungsstelle durch Bestrahlen mit fokussierter Laserstrahlung knapp neben der Verbindungsstelle vor und während des Thermokompressionsverfahrens erwärmt. Es empfiehlt sich, zur Erwärmung Laserlicht zu verwenden, da durch die hohe Leistung des Laserlichts die Erwärmung in kurzer Zeit stattfinden kann. Unter "knapp" ist zu verstehen, daß der Laserstrahl möglichst nahe an die Bondstelle heranreicht ohne bei den jeweiligen Gegebenheiten den Anschlußdraht oder die Bondkapillare zu verletzen. Um derartige Beschädigungen auf alle Fälle zu vermeiden, kann gemäß einer weiteren Ausgestaltung der Erfindung die Erwärmung der Verbindungsstelle des Trägermaterials durch den Laserstrahl von unten erfolgen.

Eine weitere Möglichkeit nach der Erfindung besteht darin, daß die Verbindungsstelle mit Laserstrahlung erwärmt wird bis eine flache Schmelzzone entsteht, in die der Anschlußdraht (z.B. ein Golddraht) in geeigneter Weise, z.B. direkt mit der Thermokompressionsdüse, hineingedrückt wird.

Im Rahmen der Erfindung ist es auch möglich, daß kurz vor dem Bondvorgang die Oberfläche an der Verbindungsstelle des Trägermaterials zum Verdampfen (Sublimieren) gebracht wird. Auf diese Weise wird eine besonders reine Oberfläche frei von Oxiden und Fremdschichten erzeugt.

0019186

Zur Durchführung des Verfahrens nach der Erfindung bei der berührungslosen Zuführung von Wärme in einem partiellen Bereich mittels eines Laserstrahls kann vorzugsweise ein Nd:YAG-Dauerstrichlaser bzw. $CO_2$-Dauerstrichlaser jeweils mit oder ohne Güteschalter Verwendung finden. Der Laserstrahl kann durch mechanische Schalter, z.B. Shutter oder Spiegel und/oder durch optische Schalter, z.B. akusto- oder elektrooptische Schalter ein- und ausgeblendet werden. Die Schalter können innerhalb oder außerhalb des optischen Resonators angebracht werden.

Ein Dauerstrichlaser oder ein Laser mit Güteschalter (Riesenimpulslaser) - Quasidauerstrichbetrieb im thermischen Gleichgewicht - bietet gegenüber einem ebenfalls auchverwendbaren Pulslaser noch den Vorteil, daß die Strahlung über längere Zeit, vor dem und während des Bondvorganges, zugeführt werden kann.

Die Strahlung eines Nd:YAG-Lasers bietet gegenüber dem ebenfalls verwendbaren $CO_2$-Laser den Vorteil, daß die Strahlung des Nd:YAG-Lasers von den Metalloberflächen stärker als die langwelligere $CO_2$-Laserstrahlung absorbiert wird, wodurch ein besserer Wirkungsgrad erreicht werden kann.

Im Rahmen der Erfindung kann jedoch auch insbesondere zur Erzeugung einer flachen kleinen Schmelzzone bzw. zur Verdampfung der Oberflächenschichten ein Blitzlampen-Pulslaser verwendet werden. Durch einen Einzelpuls oder eine Pulsfolge wird die Erwärmung und/oder Aufschmelzung der Verbindungsstelle bzw. die Verdampfung der getroffenen Oberfläche erreicht. EineWeiterbildung

0019186

der Erfindung besteht darin, daß die Strahlung des Lasers zeitlich und/oder räumlich aufgespalten und über Glasfaserleitungen oder Spiegelsysteme der eigentlichen Verbindungsstelle zugeführt wird. Diese Lösung führt zu einer weiteren Kostenreduzierung.

Um eine kurze Taktzeit bei möglichst geringer Laserleistung zu erreichen, können die Verbindungsstellen der Anschlußebenen z.B. durch einen Heiztisch vorgewärmt werden. Dies führt zu einer Einsparung von Laserenergie.

Genauso vorteilhaft ist es, statt eines Lasers fokussierte IR- bzw. UV-Strahlung oder einen Lichtstrahl zu verwenden.

10 Patentansprüche

VPA   79 P 7067

Patentansprüche

1. Verfahren zum Befestigen der Anschlußdrähte von
Halbleiterbauelementen (z.B. Transistoren oder IC's)
auf Anschlußelementen (z.B. Systemträger oder
Einbaugehäusen) durch Thermokompression, dadurch gekennzeichnet, daß durch ein berührungsloses Zuführen von
Wärme in einem partiellen Bereich mittels Laserstrahlung,
fokussierter IR-Strahlung, UV-Strahlung oder fokussiertem
Licht die Thermokompression auf unedlen Oberflächen
der Verbindungsstellen bei relativ niedriger Temperatur
durchgeführt und dabei in bekannter Weise zur Vermeidung von Oxidation des Trägermaterials Schutzgas verwendet wird.

2. Verfahren nach Anspruch 1, dadurch gekennzeichnet, daß
die Verbindungsstelle durch Bestrahlen mit fokussierter
Laserstrahlung knapp neben der Verbindungsstelle vor und
während des Thermokompressionsvorgangs erwärmt wird.

3. Verfahren nach Anspruch 2, dadurch gekennzeichnet, daß
die Erwärmung der Verbindungsstelle des Trägermaterials
durch den Laserstrahl von unten erfolgt.

4. Verfahren nach Anspruch 1, dadurch gekennzeichnet, daß
die Verbindungsstelle mit Laserstrahlung erwärmt wird bis
eine flache Schmelzzone entsteht, in die der Anschlußdraht (z.B. ein Golddraht) in geeigneter Weise hineingedrückt wird.

5. Verfahren nach Anspruch 1, dadurch gekennzeichnet, daß
kurz vor dem Bondvorgang die Oberfläche an der Verbindungsstelle zum Verdampfen (Sublimieren) gebracht wird.

6. Verfahren nach den Ansprüchen 1 bis 5, dadurch gekennzeichnet, daß ein Nd:YAG-Dauerstrichlaser bzw. ein $CO_2$-Dauerstrichlaser jeweils mit oder ohne Güteschalter Verwendung findet.

7. Verfahren nach Anspruch 6, dadurch gekennzeichnet, daß ein Dauerstrichlaser mit einem Schaltelement außerhalb des Resonators verwendet wird.

8. Verfahren nach den Ansprüchen 1 bis 5, dadurch gekennzeichnet, daß ein Blitzlampen-gepumpter Pulslaser vorgesehen ist.

9. Verfahren nach den Ansprüchen 6 bis 8, dadurch gekennzeichnet, daß die Strahlung des Lasers zeitlich und/oder räumlich aufgespalten und über Glasfaserleitungen oder Spiegelsysteme der eigentlichen Verbindungsstelle zugeführt wird.

10. Verfahren nach Anspruch 1, dadurch gekennzeichnet, daß die Verbindungsstellen der Anschlußstellen vorgewärmt werden.

| | | | |
|---|---|---|---|
| **Europäisches Patentamt** | **EUROPÄISCHER RECHERCHENBERICHT** | Nummer der Anmeldung | EP 80 10 2439 |

## EINSCHLÄGIGE DOKUMENTE

| Kategorie | Kennzeichnung des Dokuments mit Angabe, soweit erforderlich, der maßgeblichen Teile | betrifft Anspruch | KLASSIFIKATION DER ANMELDUNG (Int.Cl. 3) |
|---|---|---|---|
| | GB - A - 1 250 847 (WELWYN ELECTRIC)<br><br>* Patentansprüche 1,4-6; Seite 4, Zeilen 90-94 *<br><br>-- | 1,2 | H 01 L 21/48<br>21/603<br>21/60 |
| | US - A - 3 409 977 (TEXAS)<br><br>* Patentanspruch 1; Spalte 5, Zeilen 2,3; Spalte 5, Zeilen 19-22 *<br><br>-- | 1,4,10 | |
| | IBM TECHNICAL DISCLOSURE BULLETIN, Band 21, Nr. 6, November 1978 NEW YORK (US)<br>P. CHAUDHARI et al.: "Bonding wires to microcircuitry", Seiten 2549-2550.<br><br>* Seite 2549, Abschnitte 3,4 *<br><br>---- | 1,8 | **RECHERCHIERTE SACHGEBIETE (Int. Cl. 3)**<br><br>H 01 L 21/48<br>21/603<br>21/60 |

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patent- familie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 04-09-1980 | DE RAEVE |

EPA form 1503.1 06.78